(19) Europäisches Patentamt
European Patent Office
Office européen des brevets

(11) **EP 1 961 051 B1**

(12) **EUROPEAN PATENT SPECIFICATION**

(45) Date of publication and mention
of the grant of the patent:
**11.11.2015 Bulletin 2015/46**

(51) Int Cl.:
**H01L 35/00** (2006.01)    **H01J 45/00** (2006.01)

(21) Application number: **06849248.7**

(86) International application number:
**PCT/US2006/047587**

(22) Date of filing: **13.12.2006**

(87) International publication number:
**WO 2007/081483 (19.07.2007 Gazette 2007/29)**

(54) **METHOD FOR CREATING THERMOELECTRIC TUNNELLING DEVICE**

VERFAHREN ZUR HERSTELLUNG EINER THERMOELEKTRISCHEN TUNNELUNGSVORRICHTUNG

PROCEDE DE FABRICATION D'UN DISPOSITIF A EFFET DE TUNNEL THERMOELECTRIQUE

(84) Designated Contracting States:
**AT BE BG CH CY CZ DE DK EE ES FI FR GB GR HU IE IS IT LI LT LU LV MC NL PL PT RO SE SI SK TR**

(30) Priority: **15.12.2005 US 304085**

(43) Date of publication of application:
**27.08.2008 Bulletin 2008/35**

(73) Proprietor: **THE BOEING COMPANY**
**Chicago, IL 60606-2016 (US)**

(72) Inventor: **TANIELIAN, Minas, H.**
**Bellevue, WA 98006-3148 (US)**

(74) Representative: **Land, Addick Adrianus Gosling et al**
**Arnold & Siedsma**
**Bezuidenhoutseweg 57**
**2594 AC Den Haag (NL)**

(56) References cited:
**WO-A-2006/081102        DE-A1- 3 818 192**
**US-A1- 2004 189 141     US-A1- 2004 195 934**
**US-A1- 2005 016 575     US-A1- 2005 247 337**
**US-B1- 6 403 876**

• **SUNGTAEK JU Y ET AL: "Study of interface effects in thermoelectric microrefrigerators" JOURNAL OF APPLIED PHYSICS, AMERICAN INSTITUTE OF PHYSICS. NEW YORK, US, vol. 88, no. 7, 1 October 2000 (2000-10-01), pages 4135-4139, XP012051707 ISSN: 0021-8979**

**Description**

The present disclosure relates generally to electrical power generation and, more specifically, to direct thermal-to-electric energy conversion power generating systems.

Solid state thermal engines are devices that perform direct thermal-to-electric energy conversion without any moving parts. The solid state thermal engine is driven by hot sources, such as engine bleed air, wasted heat from operation of an electromechanical or thermal system, or some other heat source, such as the sun.

Solid state thermal engine technology is based on thermionics. Thermionics originated nearly a century ago with a basic vacuum tube, a device that consisted of two parallel conductive plates (a high temperature cathode and a low temperature anode) separated by a vacuum gap. During operation electrons boil off the cathode, traverse the gap and then are absorbed into the colder anode. The conversion of heat to electricity occurs as the electrons' kinetic energy results in a net current between the anode and cathode. These early vacuum gap designs have high manufacturing costs and high operating temperatures-above 1000 degrees Centigrade, and require a very small gap for operation, on the order of hundreds of nanometers.

US 2004/195934 discloses a method for creating a thermo tunneling device, comprising: depositing a metal/semiconductor structure that allows current flow between a hot plate and a cold plate of the thermotunneling device and interrupting a flow of phonons between the hot plate and the cold plate of the thermotunneling device, wherein the interrupted flow is created by a vacuum nanogap, said vacuum nanogap being formed by passing a current between opposing electrodes located respectively at the hot and cold side of the device.

To minimize the limitations in the prior art, and to minimize other limitations that will become apparent upon reading and understanding the present specification, embodiments of the present invention provides a method for creating a solid state thermal engine, also known as a thermotunneling device, comprising depositing a metal/semiconductor structure that allows current flow between a hot plate and a cold plate of the thermotunneling device and interrupting a flow of phonons between the hot plate and the cold plate of the thermotunneling device, wherein the interrupted flow is created by a vacuum nanogap, said vacuum nanogap being formed by passing a current between opposing electrodes located respectively at the hot and cold side of the device, characterized in that the deposited material comprises at least two columns of semiconductor material, a first column comprising a first dopant type of semiconductor material and a second column comprising a second dopant type of semiconductor material.

A device produced according to the method of any of claims 1-4 comprises a material that allows electron flow between a hot plate and a cold plate of the thermotunneling device, and an additional layer, between the hot plate and the cold plate of the thermotunneling device, wherein the additional layer interrupts a flow of phonons between the hot plate and the cold plate of the thermotunneling device.

Such a device optionally further includes the material that allows electron flow being a metal/semiconductor junction, where there is a vacuum nanogap between the metal and semiconductor sufaces, the vacuum nanogap between the surfaces is formed by passing a current between opposing electrodes located respectively at a hot and a cold side of the thermotunneling device. The material that allows electron flow comprises at least one columns of semiconductor material or preferably two columns of semiconductor material, a first column comprising a first dopant type of semiconductor material and a second column comprising a second dopant type of semiconductor material, and the flow of phonons being interrupted by a vacuum nanogap within at least one of the columns of semiconductor material said vacuum nanogap being formed by passing a current between opposing electrodes located respectively at the hot and cold plates of the thermotunneling device.

BRIEF DESCRIPTION OF THE DRAWINGS

Referring now to the drawings in which like reference numbers represent corresponding parts throughout:

FIG. 1 is a cross-sectional view of a solid state thermal engine according to the related art;
FIG. 2 illustrates a device in accordance with an embodiment;
FIGS. 3A-3F illustrate process steps used to fabricate a device in accordance with the present invention;
FIGS. 4A-4F illustrate process steps used to fabricate a device in accordance with the present invention;
FIG. 5 illustrates an alternative embodiment of the present invention; and
FIG. 6 is a flowchart illustrating the steps of the present invention.

DETAILED DESCRIPTION OF THE PREFERRED EMBODIMENTS

In the following description, reference is made to the accompanying drawings which form a part hereof, and which is shown, by way of illustration, several embodiments of the present invention. It is understood that other embodiments may be utilized and structural changes may be made without departing from the scope of the present invention.

Overview

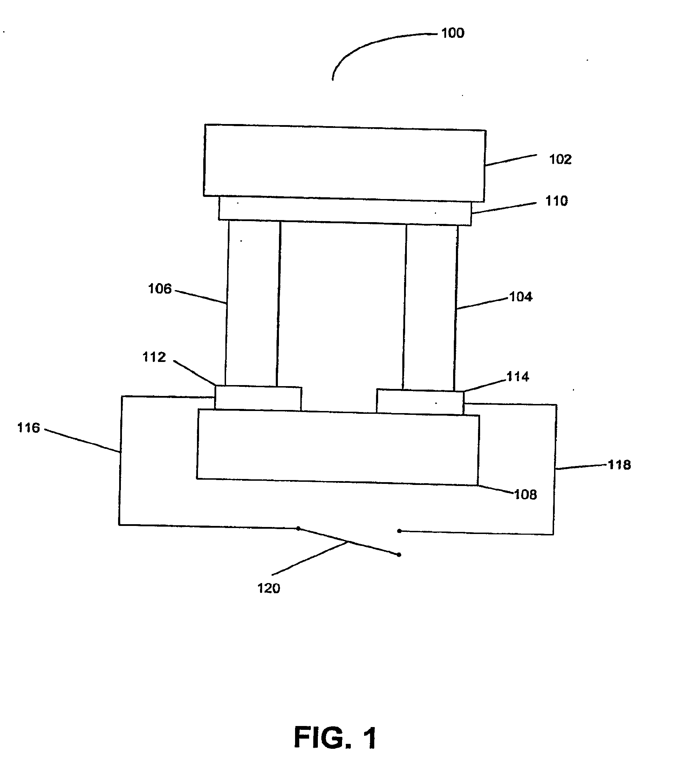

FIG. 1 is a cross-sectional view of a solid state thermal engine according to the related art.

Device 100 comprises a hot electrode 102, an n-type column 104, a p-type column 106, a cold electrode 108, an ohmic contact 110 between hot electrode 102 and both columns 104 and 106, an ohmic contact 112 between p-type column 106 and cold electrode 108, and an ohmic contact 114 between n-type column 104 and cold electrode 108. Conductor 116 is coupled to contact 112, conductor 118 is coupled to contact 114, and switch 120 is also provided, to allow for a load to be connected across the device 100.

In device 100, the thermoelectric elements, namely, the n-type column 104 and p-type column 106, transport carriers away from the hot electrode 102 and toward the cold electrode 108. However, in the p-type column 106, the carriers moving to cold electrode 108 are, positive charges (holes) moving toward the hot electrode 102, and current generated in conductors 116 and 118 when switch 120 is closed is the sum of the currents flowing in columns 106 and 104. The current flow in device 100 is from contact 112 to contact 114. Typically, the contacts 110, 112, and 114 are metal contacts and 106 and 104 semiconductor materials, which in combination provide a thermal path between hot electrode 102 and cold electrode 108, which reduces the temperature difference between the hot electrode 102 and cold electrode 108, thus reducing the current flow and the efficiency of device 100.

The present invention employs semiconductor contacts, and a vacuum gap within the columns, to reduce the thermal path that is provided by the semiconductor columns, which allows for a larger temperature difference to be maintained between the hot and cold side of the device. In essence, devices in accordance with the present invention allow for electron flow between the hot and cold plates of a thermoelectric device, but interrupt phonon flow in the thermoelectric device by using various different thermal interruption mechanisms. The interruption mechanisms are vacuum gaps, that are created in the thermotunneling device along the current path, which reduce the thermal conductivity of the thermal path between hot electrode 102 and cold electrode 108.

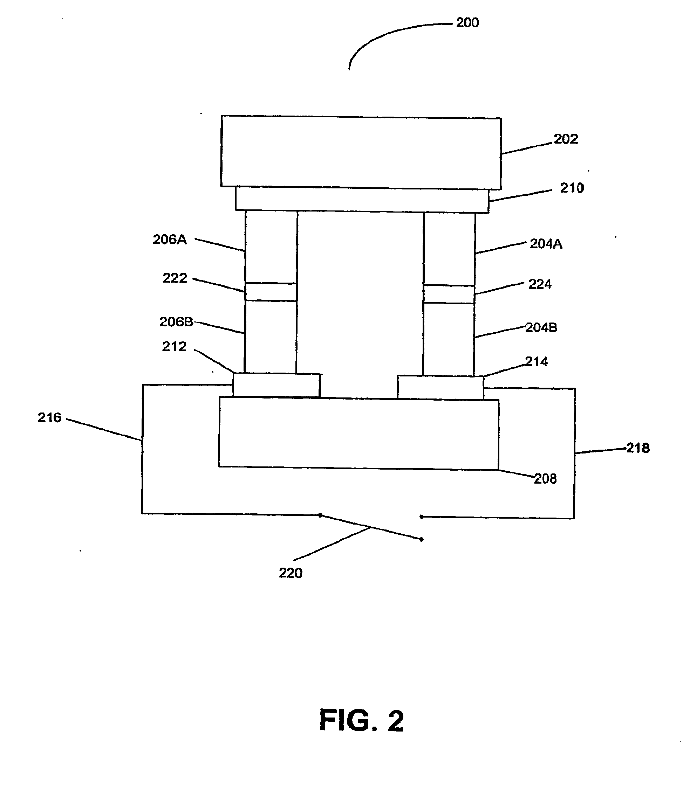

FIG. 2 illustrates a device in accordance with an embodiment.

Device 200 comprises a hot electrode 202, an n-type column 204A and 204B, a p-type column 206A and 206B, a cold electrode 208, a contact 210 between hot electrode 202 and both columns 204A and 206A, a contact 212 between p-type column 206B and cold electrode 208, and a contact 214 between n-type column 204B and cold electrode 208. Conductor 216 is coupled to contact 212, conductor 218 is coupled to contact 214, and switch 220 is also provided, to allow for a load to be connected across the device 200. Device 200 also comprises gaps 222 and 224, which are vacuum gaps 222 and 224, where vacuum gap 222 is shown as being approximately in the center of the column defined by column 206A and column 206B, and vacuum gap 224 is shown as being approximately in the center of the column defined by column 204A and column 204B. However, vacuum gaps 222 and 224 can be placed at any point between contact 210 and contacts 212 and 214, and can be placed at different distances between contacts 210 and 212/214 if desired. For example, and not by way of limitation, gap 222 can be placed closer to cold electrode 208, and gap 224 can be placed closer to hot electrode 202, without departing from the scope of the present invention.

Vacuum gaps 222 and 224 serve to break up the thermal conductivity of the device 200 compared to device 100 of the related art. The figure of merit, Z, for a given material is given by $Z = \Pi^2 / \varkappa \varrho$, where $\Pi$ is the Peltier coefficient, $\varkappa$ is the thermal conductivity of the material, and $\varrho$ is the electrical resistivity. For a given material, the thermal conductivity and the electrical resistivity are related, and, essentially, materials that have low electrical resistivity have high thermal conductivity. Metals, used for ohmic contacts, are excellent charge carriers and also excellent conductors of heat, and, as such, the ratio is relatively unchanged as the product of the two terms varies inversely with each other. However, materials that have a nanogap, or, in the case of the present invention, vacuum gaps 222 and 224, change the rules, because the electrical resistivity, due to the presence of the nanogap, although it increases it does not do so very significantly , since electrons can readily tunnel through a very narrow gap typically on the order of 0.5-1 nm but the thermal conductivity gets dramatically reduced because phonons cannot, thus resulting in a low effective thermal conductivity, the final result being a net increase in Z. The lowered thermal conductivity is caused by the nanogap (vacuum gaps 222 and 224) blocking phonon flow from the hot electrode 202 to the cold electrode 204, but tunelling electrons through gaps 222 and 224 maintain the electrical resistivity at a relatively constant value.

Fabrication Methodologies

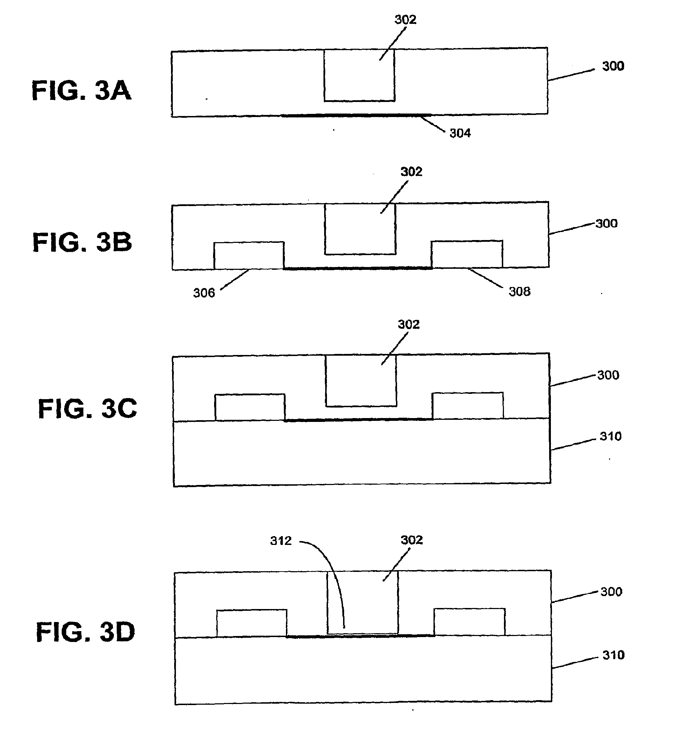

FIGS. 3A-3F illustrate process steps used to fabricate a device in accordance with the present invention.

In FIG. 3A, glass sheet 300 with trench 302 is shown. A layer of metal 304, typically gold, is deposited using standard deposition techniques. Such techniques include sputtering, vapor deposition, and other techniques. Further, although gold is typically used, other metals, such as silver, aluminum, platinum, nickel, tungsten, or other metals can be used within the scope of the present invention. FIG. 3B shows trenches 306 and 308 that are etched in glass sheet 300.

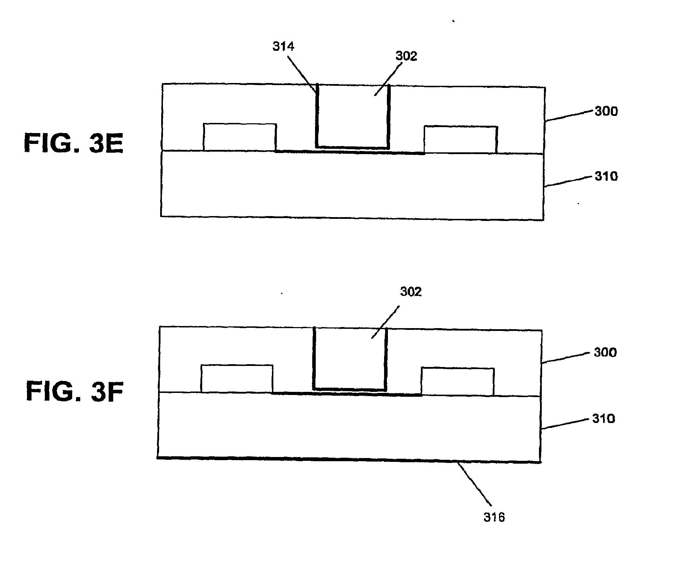

FIG. 3C then shows bonding of glass sheet 300 to a semiconductor wafer 310. Typically, wafer 310 is silicon, but can be other semiconductor materials without departing from the scope of the present invention. Wafer 310 is doped and it can have a graded doping, with the highest doping being at the back side of the wafer 310 (away from the glass sheet 300). The bonding of glass sheet 300 to wafer 310 is done using typical bonding processes. FIG. 3D shows that trench 302 has been etched deeper until the metal layer 304 is electrically accessible through the via, by increasing depth 312 of trench 302, FIG. 3E shows that the trench 302 has been metallized with metal 314 that electrically contacts metal 304, and FIG. 3F shows that the back of wafer 310 has been metallized with metal 316. Metals 314 and 316 can be gold, or aluminum, silver, nickel, tungsten, or other metals, and can be different than each other if desired. Metal 316 contacts the back side of the wafer in an ohmic contact. Contacts 314 and 316 electrically correspond to contacts 210 and 212 in Figure 2.

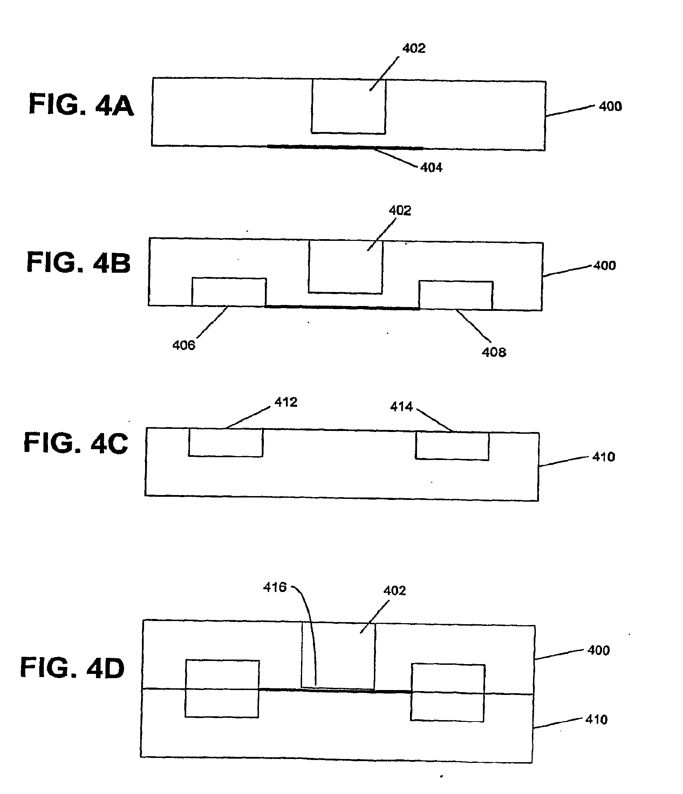

FIGS. 4A-4F illustrate process steps used to fabricate a device in accordance with the present invention.

In FIG. 4A, glass sheet 400 with trench 402 is shown. A layer of metal 404, typically gold, is deposited using standard deposition techniques. Such techniques include sputtering, vapor deposition, and other techniques. Further, although gold is typically used, other metals, such as silver, aluminum, platinum, nickel, tungsten, or other metals can be used within the scope of the present invention. FIG. 4B shows trenches 406 and 408 that are etched in glass sheet 400.

FIG. 4C shows wafer 410, with trenches 412 and 414. Wafer 410 is a semiconductor wafer, typically silicon, but can be other semiconductor materials if desired, whose doping on the surface may be different than its bulk and it may consist of two differently doped layers. FIG. 4D then shows bonding of glass sheet 400 to wafer 410. The bonding of glass sheet 400 to wafer 410 is done using typical bonding processes. Glass sheet 400 is also etched such that trench 402 is deeper, as shown by depth 416 to reach metal layer 404.

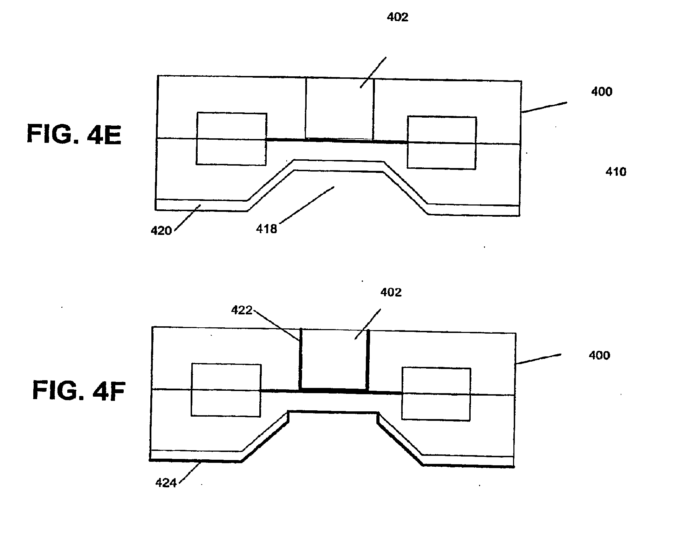

FIG. 4E shows an etch 418 of wafer 410, which is done to a depth of the dopant layer in wafer 410. Further, oxide 420 is grown on the back of wafer 410. FIG. 4F shows etching of the oxide 420, metallization 422 of trench 402, and metallization 424 of the trench 418 with the oxide 420 removed from the contact area. Metallizations 422 and 424 can be gold, or aluminum, silver, nickel, tungsten, or other metals, and can be different than each other if desired as long as they provide an ohmic contact.

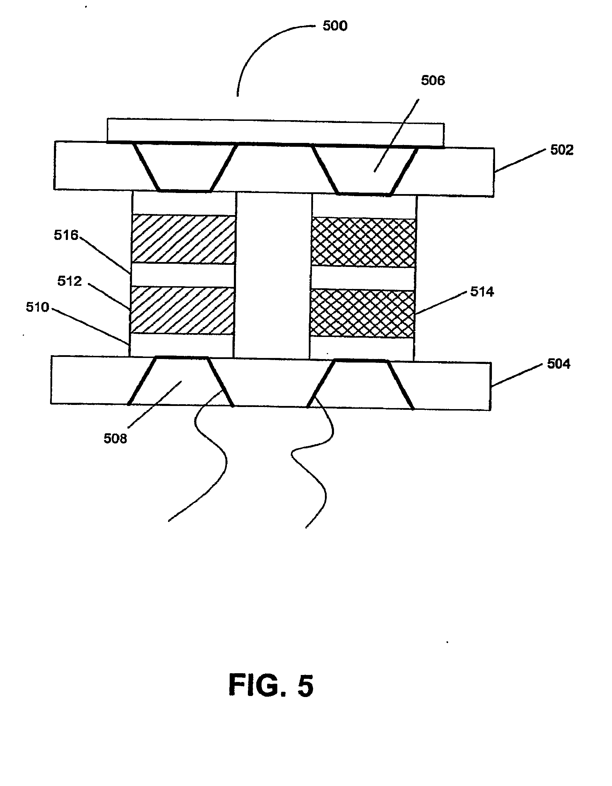

FIG. 5 illustrates an alternative embodiment of the present invention.

Device 500 is shown, comprising glass sheet 502 and glass sheet 504. Glass sheet 502 has trenches 506, while glass sheet 504 has trenches 508. In essence, glass sheet 502 is a mirror image of glass sheet 504.

Glass sheet 504 has an ohmic contact 510, and semiconductor columns 512 and 514, where column 512 is of a different dopant type than column 514. The glass sheets 502 and 504 are bonded together at interface 516.

In general, metal to metal electrodes separated by a very thin vacuum gap when made into a thermotunneling device do not have high efficiency. The reason is there are very many electrons that can cross the gap from one metal electrode to the other even though the net flow is still from the high temperature side to the cold side. In other words the thermoelectric current is a small difference between two large currents. These two large electron currents effectively increase the thermal conductivity of the nanogap because electrons do not carry only electricity but also thermal energy. Thus, the efficiency of a metal to metal electrode thermotunneling device is low. In contrast, a metal/semiconductor junction (Schottky contact) or a semiconductor/semiconductor junction, such as a p-n junction allow only energetic electrons to flow or unidirectional electron flow, such that despite of the fact that the number of carriers is small compared with the metal/metal case the thermoelectric conversion efficiency is high, since the average energy transported per electron that crosses the vacuum gap is much higher.

The method via which a nanogap is formed between two contacts such as those between metallic layer 304 and wafer 310 (Figure 3), metallic layer 404 and wafer 410 (Figure 4), semiconductor layer 312 or 314 and their mirror image (Figure 5) is as follows: A constant voltage or constant current that exceeds a predefined value is applied across the two opposing electrodes in order to form a nano-gap between the two electrodes. Examples of the predefined voltage and current values are a voltage of 2V or a current of several hundred milliamperes. The applied voltage or current is done at small increments until an abrupt change in the effective resistance of the interface is measured, not unlike the "burning" of a fuse, although done in a controlled manner. When a voltage is applied across the electrodes, Joule heating and strong electromigration effects take place. Joule heating is the heat which is evolved when current flows through a medium having electrical resistance, as given by Joule's law. Electromigration drives atoms along grain boundries in polycrystals due to the presence of an electric field. The result is a rearrangement of the polycrystalline structure. Electromigration effects are well known in semiconductor technology where they often lead to the creation of voids in integrated circuit interconnects, thus causing them to fail. This process happens because there are native nano-defects between the two opposed electrode surfaces which are the result of incomplete bonding during the wafer bonding process. Flowchart

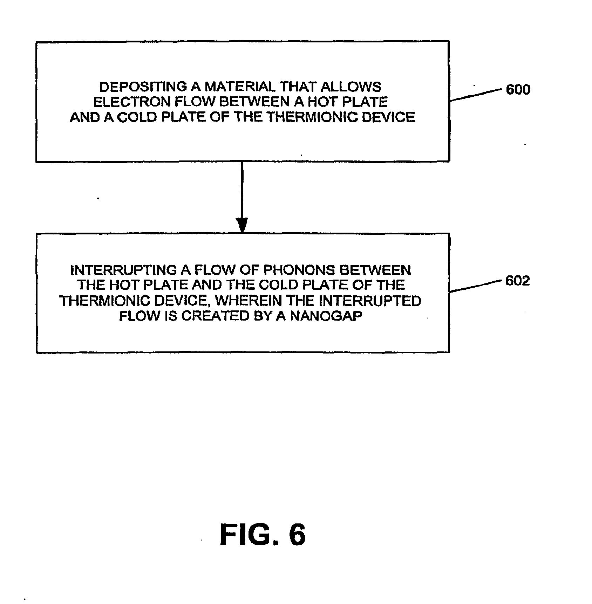

FIG. 6 is a flowchart illustrating the steps of the present invention.

Box 600 illustrates depositing a material that allows electron flow between a hot plate and a cold plate of the thermotunneling device.

Box 602 illustrates interrupting a flow of phonons between the hot plate and the cold plate of the thermotunneling device, wherein the interrupted flow is created by a nanogap.

Conclusion

In summary, embodiments of the invention provide methods and apparatuses for making a thermotunneling device.

A method in accordance with the present invention comprises depositing a material that allows current flow between a hot plate and a cold plate of the thermotunneling device, and interrupting the flow of phonons (thermal energy) between the hot plate and the cold plate of the thermotunneling device, wherein the interrupted flow is created by a vacuum nanogap.

Such a method further includes the deposited material being a metal, the deposited material comprising at least two columns of semiconductor material, a first column comprising a first dopant type of semiconductor material and a second column comprising a second dopant type of semiconductor material, the flow of phonons being interrupted by a layer within at least one of the columns of semiconductor material, the layer within at least one of the columns being a vacuum gap, and the flow being interrupted by at least one metal/semiconductor contact on the thermotunneling device.

A device in accordance with an embodiment comprises a material that allows electron flow between a hot plate and a cold plate of the thermotunneling device, and an additional layer, between the hot plate and the cold plate of the thermotunneling device, wherein the additional layer interrupts a flow of phonons between the hot plate and the cold plate of the thermotunneling device. Such a device optionally further includes the material that allows electron flow being a metal/semiconductor junction, where there is a vacuum nanogap between the metal and semiconductor sufaces, the vacuum nanogap between the surfaces is formed by passing a current between opposing electrodes located respectively at a hot and a cold side of the thermotunneling device, the material that allows electron flow comprises at least two columns of semiconductor material, a first column comprising a first dopant type of semiconductor material and a second column comprising a second dopant type of semiconductor material, and the flow of phonons being interrupted by a vacuum nanogap within at least one of the columns of semiconductor material said vacuum nanogap being formed by passing a current between opposing electrodes located respectively at a hot and a cold side of the thermotunneling device.

The foregoing description of the preferred embodiment of the invention has been presented for the purposes of illustration and description. It is not intended to be exhaustive or to limit the invention to the precise form disclosed. Many modifications and variations are possible in light of the above teaching. It is intended that the scope of the invention be limited not by this detailed description, but rather by the claims appended hereto.

**Claims**

1. A method for creating a thermotunneling device (100), comprising:

   depositing a metal/semiconductor structure that allows current flow between a hot plate and a cold plate of the thermotunneling device; and interrupting a flow of phonons between the hot plate and the cold plate of the thermotunneling device, wherein the interrupted flow is created by a vacuum nanogap (222), said vacuum nanogap being formed by passing a current between opposing electrodes (202, 208) located respectively at the hot and cold side of the device,
   **characterized in that** the deposited material comprises at least two columns of semiconductor material, a first column (206B) comprising a first dopant type of semiconductor material and a second column (202B) comprising a second dopant type of semiconductor material.

2. The method of claim 1, wherein the flow of phonons is interrupted by a layer within at least one of the columns of semiconductor material.

3. The method of claim 2, wherein the layer within at least one of the columns is a vacuum gap.

4. The method of any of claims 1-3, wherein the flow is interrupted by at least one metal/semiconductor contact on the thermotunneling device.

**Patentansprüche**

1. Verfahren zur Herstellung einer Thermotunnel-Vorrichtung (100), umfassend:

   Ablagern einer Metall/Halbleiter Struktur, die einen Stromfluss zwischen einer heißen Platte und einer kalten Platte der Thermotunnel-Vorrichtung ermöglicht; und
   Unterbrechen eines Phononflusses zwischen der heißen Platte und der kalten Platte der Thermotunnel-Vorrichtung, wobei der unterbrochene Fluss durch ein Vakuum- Nanoabstand (222) erzeugt wird, wobei dieses Vakuum- Nanoabstand durch Leiten von Strom zwischen gegenüberliegenden Elektroden (202, 208), die sich jeweils auf der heißen und der kalten Seite der Vorrichtung befinden, geschaffen wird,
   **dadurch gekennzeichnet, dass** das abgelagerte Material wenigstens zwei Säulen von Halbleitermaterial umfasst, wobei eine erste Säule (206B) einen ersten Dotierungsmaterialtyp von Halbleitermaterial umfasst und eine zweite Säule (202B) einen zweiten Dotierungsmaterialtyp von Halbleitermaterial umfasst.

2. Verfahren gemäß Anspruch 1, wobei der Phononfluss durch eine Schicht innerhalb wenigstens einer der Säulen von Halbleitermaterial unterbrochen wird.

3. Verfahren gemäß Anspruch 2, wobei es sich bei der Schicht innerhalb wenigstens einer der Säulen um einen Vakuumabstand handelt.

4. Verfahren gemäß einem der Ansprüche 1 bis 3, wobei der Fluss durch wenigstens einen Metall/Halbleiter Kontakt an der Thermotunnel-Vorrichtung unterbrochen wird.


**Revendications**

1. Procédé de création d'un dispositif à effet thermotunnel (100), comprenant:

   le dépôt d'une structure métal/semi-conducteur permettant un flux de courant entre une plaque chaude et une plaque froide du dispositif à effet thermotunnel; et
   l'interruption d'un flux de phonons entre la plaque chaude et la plaque froide du dispositif à effet thermotunnel, dans lequel le flux interrompu est créé par un nano-intervalle de vide (222), ledit nano-intervalle de vide étant formé en faisant passer un courant entre des électrodes opposées (202, 208) situées respectivement sur les côtés chaud et froid du dispositif,
   **caractérisé en ce que** le matériau déposé comprend au moins deux colonnes de matériau semi-conducteur, une première colonne (206B) comprenant un premier type de dopant de matériau semi-conducteur et une seconde colonne (202B) comprenant un second type de dopant de matériau semi-conducteur.

2. Procédé selon la revendication 1, dans lequel le flux de phonons est interrompu par une couche au sein d'au moins une des colonnes de matériau semi-conducteur.

3. Procédé selon la revendication 2, dans lequel la couche au sein d'au moins une des colonnes est un intervalle de vide.

4. Procédé selon l'une quelconque des revendications 1 à 3, dans lequel le flux est interrompu par au moins un contact métal/semi-conducteur présent sur le dispositif à effet thermotunnel.

**FIG. 1**

FIG. 2

**FIG. 3A**

302

300

304

**FIG. 3B**

302

300

306

308

**FIG. 3C**

302

300

310

**FIG. 3D**

312

302

300

310

**FIG. 3E**

**FIG. 3F**

FIG. 4A

402

400

404

FIG. 4B

402

400

406

408

FIG. 4C

412

414

410

FIG. 4D

416

402

400

410

**FIG. 4E**

402

400

410

420    418

**FIG. 4F**

422    402

400

424

**FIG. 5**

DEPOSITING A MATERIAL THAT ALLOWS
ELECTRON FLOW BETWEEN A HOT PLATE
AND A COLD PLATE OF THE THERMIONIC DEVICE

— 600

INTERRUPTING A FLOW OF PHONONS BETWEEN
THE HOT PLATE AND THE COLD PLATE OF THE
THERMIONIC DEVICE, WHEREIN THE INTERRUPTED
FLOW IS CREATED BY A NANOGAP

— 602

# FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2004195934 A